**Europäisches Patentamt**

(19) **European Patent Office**

**Office européen des brevets**

(11) Numéro de publication: **0 063 069**
**B1**

(12) **FASCICULE DE BREVET EUROPEEN**

(45) Date de publication du fascicule du brevet:
27.11.85

(51) Int. Cl.⁴: **H 03 H 9/42**, G 06 G 7/195

(21) Numéro de dépôt: 82400557.3

(22) Date de dépôt: 26.03.82

(54) Système de traitement à ondes élastiques invariant avec la température.

(30) Priorité: 08.04.81 FR 8107034

(43) Date de publication de la demande:
20.10.82 Bulletin 82/42

(45) Mention de la délivrance du brevet:
27.11.85 Bulletin 85/48

(84) Etats contractants désignés:
DE GB IT NL

(56) Documents cités:
GB - A - 1 568 411
US - A - 3 809 931

1978 ULTRASONICS SYMPOSIUM PROCEEDINGS,
25-27 septembre 1978, Cherry Hill, NEW JERSEY (US),
D.L. SMYTHE et al.: "An acoustoelectric SAW/CCD
Device", pages 16-19
1978 ULTRASONICS SYMPOSIUM PROCEEDINGS,
25-27 septembre 1978. Cherry Hill, NEW JERSEY (US), J.
HENAFF t al.: "A SAW temperature compensated
oscillator using the difference between metallized and
free delay temperature coefficients on LiTAO3, pages
448-451

(73) Titulaire: **THOMSON-CSF, 173, Boulevard Haussmann,**
**F-75379 Paris Cedex 08 (FR)**

(72) Inventeur: **Chomiky, Michel, THOMSON-CSF**
**SCPI 173, bld Haussmann, F-75360 Paris Cedex 08 (FR)**

(74) Mandataire: **Desperrier, Jean-Louis et al,**
**THOMSON-CSF SCPI 173, Bld Haussmann,**
**F-75379 Paris Cedex 08 (FR)**

ACTORUM AG

## Description

La présente invention a pour objet la réalisation de systèmes de traitement de signaux par ondes élastiques invariants avec la température.

Les dispositifs à ondes élastiques sont utilisés pour de nombreuses applications comme par exemple: pour les lignes à retard dispersif; pour la compression d'impulsion; pour les filtres; pour les analyseurs de spectre utilisant plusieurs lignes dispersives structurées «en π» ou «en T» et pour les corrélateurs ou convoluteurs.

Pour ces applications, il importe que toute fréquence déterminée par référence au dispositif de traitement à ondes élastiques soit stable et, en particulier aussi peu dépendante que possible de la température. Dans le cas contraire, il y a une distorsion du signal de sortie, par rapport au signal de sortie attendu, qui est d'autant plus grande que les variations de température sont importantes. C'est le cas lorsque les matériels utilisant des dispositifs de traitement à ondes élastiques sont soumis à des grandes variations de température, il en est ainsi par exemple, dans le domaine des applications radar ou sonar, où le matériel est embarqué.

Afin de limiter les effets dûs aux variations de la température sur les composants à ondes élastiques, il est connu d'utiliser des substrats et des coupes pour lesquels les variations linéaires et les variations de vitesse s'annulent au premier ordre tel que, par exemple, le quartz taillé suivant la coupe appelée «ST». Cependant ces substrats présentent de faibles coefficients de couplage et on utilise généralement des substrats dont les coefficients de couplage sont élevés tels que le niobate de Lithium ($LiNbO_3$), l'Oxyde de Bismuth et de Germanium ($Bi_{12}GeO_2$) ou le Tantalate de Lithium ($LiTaO_3$). Pour ces substrats, il est connu de s'affranchir des effets dûs aux variations de température, en plaçant les dispositifs dans une enceinte thermostatique permettant de réguler la température du substrat.

On peut également, ainsi que décrit dans le brevet US, 3 809 931, recouvrir le substrat d'un film résistant et alimenter celui-ci par une tension électrique. La température du substrat est mesurée par un oscillateur à boucle de phase comportant une partie active intégrée sur le substrat. Le signal d'erreur de cette boucle de phase permet de commander la tension électrique appliquée à la couche résistive et de garder une température sensiblement constante.

Cependant ces dispositifs consomment de l'énergie et ont une inertie thermique lors de leur mise en fonction. C'est un inconvénient pour des utilisations imprévisibles de courte durée pour lesquelles la température ne sera pas stabilisée.

On peut enfin, comme décrit dans 1978 Ultrasonics Symposium Proceedings, 25–27 septembre 1978, Cherry Hill New Jersey US, article de J. HENAFF ET AL pages 448 à 451 utiliser les différences de sensibilité à la température entre deux lignes à retard à ondes de surface disposées sur un même substrat, mais dont l'une est recouverte d'une couche métallique, pour commander une compensation de l'effet de la température. Toutefois cette méthode est délicate à mettre en œuvre, et la compensation, qui n'est pas parfaite, ne s'applique qu'à la fréquence d'un oscillateur et pas à un autre dispositif de traitement.

Pour remédier à ces inconvénients, le système de traitement de signaux siuvant l'invention, permet d'obtenir une grande stabilité de fonctionnement dans une large plage de température, sans enceinte thermostatique par l'utilisation d'horloges asservies à la température, qui commandent les différents éléments du traitement de signal, permettant notamment une contraction ou une dilatation sur le temps du signal, grâce à deux mémoires à écriture et lecture.

Brièvement c'est un système de traitement de signaux, ayant des performances indépendantes de la température, utilisant un dispositif à ondes élastiques comportant au moins un substrat de propagation, caractérisé par le fait qu'un signal à traiter $S_e$ est inscrit dans une mémoire appelée «mémoire d'entrée», à la cadence d'un signal d'horloge fixe $h_E$ et que cette mémoire est lue à la cadence d'un signal d'horloge $H_L$, fourni par un générateur, asservi à la température T du ou des substrats du dispositif à ondes élastiques et que la fréquence $F_L$, du signal d'horloge $H_L$, varie avec la température T suivant la loi $\dfrac{1}{F_L} \dfrac{\delta F}{\delta T} L = K$, où K est une constante dépendant du matériau et de la coupe du ou des substrats.

D'autres caractéristiques et avantages ressortiront de la description qui va suivre, illustré par des dessins qui représentent:

– figure 1, un dispositif à ondes de surface;
– figure 2, le schéma général de traitement de signaux par un dispositif à ondes élastiques, suivant l'invention;
– figure 3, le schéma de traitement du signal, par un dispositif à ondes élastiques, par asservissement des horloges par un second dispositif à ondes élastiques;
– figure 4, un dispositif de compression d'impulsion invariant en température siuvant l'invention;
– figure 5, un schéma de mise sur porteuse d'un signal à partir de composantes complexes;
– figure 6, un schéma de démodulation complexe;
– figures 7, 8 et 9, des diagrammes montrant la variation de la compression d'impulsion d'une ligne dispersive en fonction de la température;
– figure 10, le schéma d'un analyseur de fréquence par des dispositifs à ondes élastiques.

Un dispositif à ondes élastiques comporte généralement un substrat piézoélectrique cristallin, à la surface duquel des éléments transducteurs électromécaniques assurent l'entrée et la sortie des signaux électriques.

Par exemple, les transducteurs sont constitués de peignes métalliques interdigités et les ondes élastiques du type Rayleigh sont générées en surface.

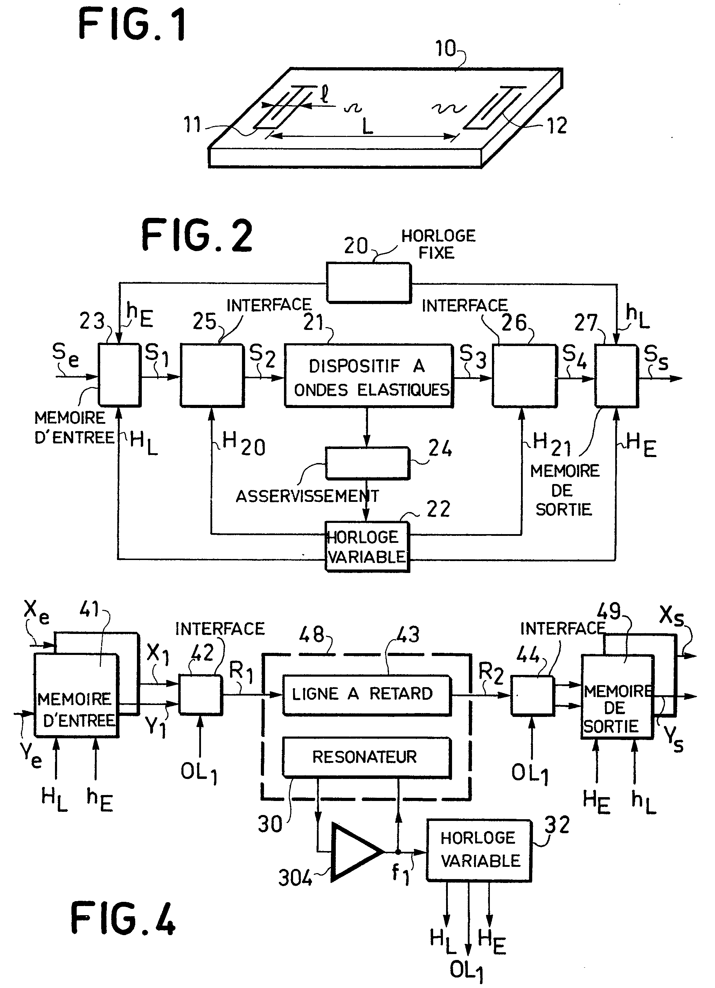

Un tel dispositif est représenté sur la figure 1. Sur cette figure on a représenté un substrat 10 sur lequel on a déposé deux peignes interdigités 11 et 12 distants de la longueur L. Une variation de la température se traduit d'une part par une modification des dimensions $l$ et L, et par une modification de la vitesse V des ondes élastiques, où $l$ est la distance entre deux doigts adjacents d'un peigne.

Il est connu que cette distance entre deux doigts adjacents l est choisie égale à la longueur d'onde ou à un multiple de la longueur d'onde élastique et fixe ainsi la fréquence d'utilisation du dispositif. C'est ainsi que V étant la vitesse de propagation des ondes, la fréquence d'utilisation peut, en particulier, être prise égale à $F = \dfrac{V}{l}$    (1).

Pour la distance L parcourue par une onde à la fréquence F entre les deux transducteurs d'entrée et de sortie, le retard de l'onde entre l'entrée et la sortie est égal à $\tau = \dfrac{L}{V}$    (2).

La variation de la température se traduit par deux effets, par une modification des dimensions et donc de L et par une modification des constantes élastiques, qui entraîne une variation de la vitesse V de propagation.

Si T est la température, on définit pour un substrat et une coupe donnés, deux coefficients constants caractérisant l'effet de la température:
– le coefficient relatif à la vitesse:

$$\frac{1}{V} \frac{\delta V}{\delta T'}$$

– le coefficient relatif aux dimensions:

$$\frac{1}{l} \frac{\delta l}{l\,T} = \frac{1}{L} \frac{\delta L}{\delta T} \ . \qquad (3)$$

Ces deux coefficients permettent de définir les variations de la vitesse et du temps de retard au premier ordre, ce qui est généralement suffisant.

Par différentation de (1) et (2), on a:

$$\frac{1}{F} \frac{\delta F}{\delta T} = \frac{1}{V} \frac{\delta V}{\delta T} - \frac{1}{l} \frac{\delta l}{\delta T} \qquad (4)$$

et $$\frac{1}{\tau} \frac{\delta \tau}{\delta T} = \frac{1}{L} \frac{\delta L}{\delta T} - \frac{1}{\Delta} \frac{\Delta V}{\delta T} \qquad (5)$$

A partir des relations (3), (4) et (5) on trouve:

$$\frac{1}{F} \frac{\delta F}{\delta T} = -\frac{1}{\tau} \frac{\delta \tau}{\delta T} = K$$

où K est une constante pour le substrat.

Ainsi pour un motif placé à la surface d'un substrat cristallin, la fréquence propre de ce motif et le retard entrée-sortie lié à ce motif varient relativement de la même quantité, mais en sens inverse. Ces variations entrainent une désaptation du dispositif à ondes élastiques vis-à-vis su signal d'entrée, ce qui affecte sa réponse.

La figure 2 montre un synoptique général du système de traitement suivant l'invention.

Ce système de traitement comprend deux générateurs de signaux d'horloge, le premier 20 fournissant des signaux tels que $h_E$ et $h_L$ de fréquence fixe et le second des siganux tels que $H_L$, $H_{20}$, $H_{21}$, et $H_E$ de fréquence variable avec la température T du substrat du dispositif à ondes élastiques 21. Le pilote de base du second générateur 22 est asservi à la température T du substrat par un circuit d'asservissement 24.

Le circuit d'asservissement 24 reçoit la valeur de la température du dispositif, transmise par un capteur situé sur le substrat et non figuré, par exemple une thermistance, et fournit la valeur de la fréquence au pilote de base du générateur 22.

Le signal $S_e$ à traiter est écrit dans une mémoire analogique ou numérique 23 appelée mémoire d'entrée à la cadence des signaux $h_E$ de fréquence fixe. La lecture de cette mémoire 23 se fait à la cadence des signaux d'horloge $H_L$, de fréquence $F_L$ variable avec la température T. Les signaux $S_l$ lus dans la mémoire 23 sont appliqués à des circuits d'interface 25, permettant notamment de mettre le signal $S_1$ sur une fréquence porteuse adaptée au dispositif à ondes élastiques. Les fréquences des signaux tels que $H_{20}$ fournis à ce circuit d'interface 25, proviennent également du second générateur d'horloge 22 et varient avec la température T. Le signal $S_2$ fourni par ce circuit d'interface 25 est traité par le dispositif à ondes élastiques 21, fournissant un signal $S_3$. Le signal $S_3$ est appliqué à un second circuit d'interface 26 permettant notamment de démoduler ce signal. Les signaux d'oscillateur local de démodulation, $H_{21}$, sont également fournis par le second générateur d'horloge 22 et varient également avec la température.

A la sortie du second circuit d'interface 26 est obtenu un signal $S_4$ inscrit dans une seconde mémoire analogique ou numérique 27 appelée mémoire de sortie à la cadence des signaux d'horloge $H_E$ qui varient avec la température T et fournis par le second générateur d'horloge.

Finalement, la seconde mémoire 27 est lue à la cadence des signaux d'horloge $h_L$, fournis par le générateur d'horloge 20 et dont la fréquence est indépendante de la température.

Les mémoires d'entrée et de sortie 23 et 27 sont en fait des dispositifs de mémorisation comportant des mémoires tampons de manière à enregistrer le signal en temps continu. Notons que sur la figure 2 on a représenté schématiquement les deux signaux d'horloge écriture-lecture connectés directement à chaque mémoire, alors que ces deux signaux sont en réalité commutés sur l'entrée horloge de chaque mémoire lors des passages écriture-lecture et lecture-écriture.

Outre le pilote de base, le second générateur 22 comporte également un ensemble de circuits formés de multiplicateurs, ou de diviseurs, ou de changeurs de fréquence qui permettent d'obtenir le signal d'horloge de lecture de la mémoire d'entrée $H_L$, le signal d'horloge d'écriture de la mémoire de sortie $H_E$ et également d'autres signaux à fréquence pure commandant les interfaces.

Notons que les circuits d'interface 25 et 26 ne sont plus nécessaires si le signal $S_1$ peut être exploité directement par le dispositif de traitement 21 et si le signal $S_3$ peut être écrit directement dans la mémoire de sortie 27.

Dans les applications pour lesquelles le signal de sortie $S_3$ du dispositif de traitement 21 est utilisé indépendamment de l'échelle des temps et des fréquences, le système ne nécessite pas les ensembles 26 et 27. En effet, il suffit dans ce cas que le signal soit correctement traité.

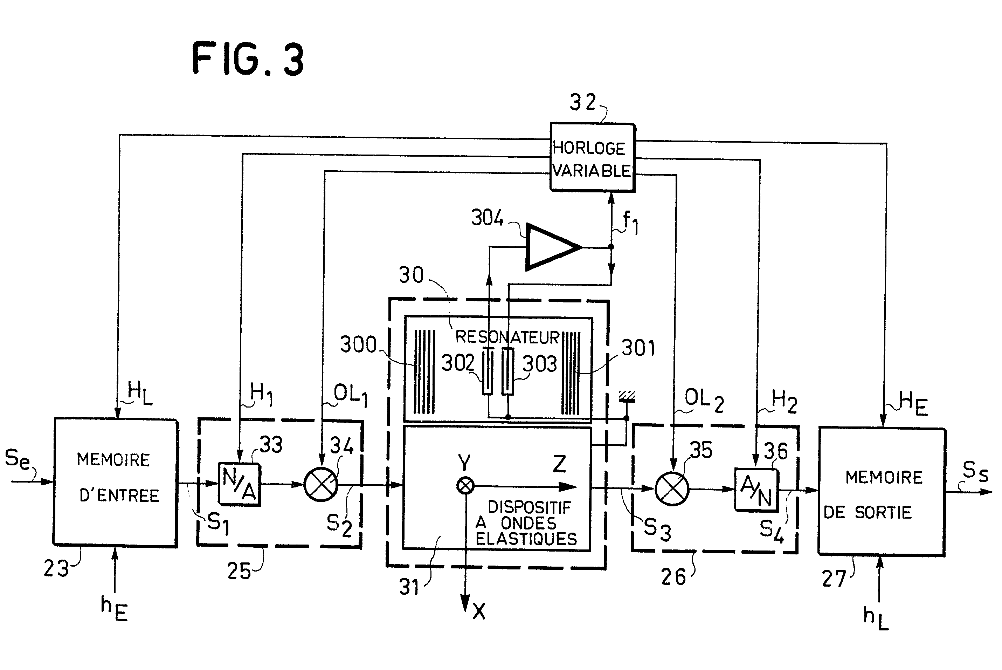

Un moyen simple pour asservir le second générateur 22 à la température du substrat du dispositif de traitement est de fabriquer le pilote de base de ce générateur par un oscillateur à ondes élastiques, réalisé avec un substrat identique à celui du dispositif de traitement. Suivant l'invention, les fonctions du capteur de température et du circuit d'asservissement 24 sont assurés par l'oscillateur à ondes élastiques qui constitue donc à lui seul le pilote de base du second générateur 22, le capteur de température et le circuit d'asservissement 24. Dans la suite de la description l'oscillateur à ondes élastiques et l'ensemble de circuits fournissant les différentes fréquences nécessaires au système est appelé «générateur asservi». La réalisation préférée de l'invention est représentée sur la figure 3.

Le dispositif de traitement de signal comprend un ou plusieurs composants à ondes élastiques 31 sur un substrat cristallin, par exemple, du Niobate de Lithium. Le cristal est taillé selon une coupe connue, par exemple, la coupe Y. Comme représenté sur cette figure, la propagation des ondes se fait suivant l'axe Z, l'axe Y étant alors dirigé vers le bas perpendiculairement au plan de la figure selon les conventions usuelles.

L'oscillateur à ondes élastiques est constitué d'un résonateur 30 à ondes élastiques de surface dont le substrat est fabriqué avec le même matériau, c'est à dire du Niobate de Lithium. Deux réseaux réfléchissants 300 et 301 gravés à la surface du substrat permettent d'obtenir une cavité résonante. Deux transducteurs 302 et 303, disposés également sur la surface sont connectés à un amplificateur 304 à grand gain, dont la sortie fournit un signal électrique de fréquence déterminée. Le Niobate de Lithium formant le substrat de ce résonateur est taillé suivant la coupe Y et la propagation des ondes élastiques entre les deux réseaux réfléchissants s'effectue suivant l'axe Z.

L'oscillateur 30 fournit une fréquence $f_1$ dont le coefficient de variation en température est:

$$\frac{1}{f_1} \frac{\delta f_1}{\delta T} = K.$$

Il est connu également de fabriquer l'oscillateur 30, 304 par une simple ligne à retard à ondes élastiques dont les deux transducteurs d'entrée et de sortie sont distants d'une longeur fonction de la fréquence $f_1$ utilisée et sont connectés à un amplificateur à grand gain.

Un ensemble de circuit 32 connecté à l'oscillateur 30, 304 permet de fabriquer les différents signaux d'horloge nécessaires au système à partir de la fréquence $f_1$, soit par boucle d'asservissement de phase, soit par division ou multiplication, soit par transposition de fréquence, soit par mélange de ces différentes techniques. Si f est l'une de ces fréquences, la variation de cette fréquence f en fonction de la température T sera telle que:

$$\frac{1}{f} \frac{\delta f}{\delta T} = \frac{1}{f_1} \frac{\delta f_1}{\delta T} = K.$$

L'oscillateur 30, 304 et l'ensemble de circuit 32 forme le générateur asservi.

Le signal d'entrée $S_e$, à traiter, provenant d'une chaîne de réception est écrit dans une mémoire numérique à écriture-lecture 23, du type appelé RAM, par exemple, à la cadence des signaux d'horloge de fréquence fixe $h_E$. Les échantillons du signal $S_1$ inscrit dans cette mémoire 23 sont lus à la cadence d'une horloge $H_L$ fabriqués de manière cohérente à partir des signaux à la fréquence $f_1$ fournis par l'oscillateur 30, 304 à l'ensemble 32.

Le signal de sortie $S_1$ de la mémoire d'entrée est lu à la période de l'horloge $H_L$ et il est converti en signal analogique par un convertisseur 33 commandé par un signal d'horloge $H_1$ élaboré par le générateur asservi selon l'une des techniques énoncées précédemment.

Le signal de sortie du convertisseur 33 est envoyé dans un circuit changeur de fréquence 34 qui effectue une mise sur porteuse du signal, commandé par le signal $OL_1$ élaboré par le générateur asservi selon l'une des techniques énoncées précédemment. En sortie du changeur de fréquence 34, le signal $S_2$ est à une fréquence centrale permettant de le traiter dans le dispositif comportant des composants à ondes élastiques 31. Cette fréquence est de l'ordre de quelques dizaines de MHz.

Le signal de sortie $S_3$ du dispositif de traitement 31 est traité de manière symétrique à l'entrée dans la chaîne de traitement de sortie 26 aboutissant à écrire dans une autre mémoire numérique 27, le signal traité numérisé. Le circuit changeur de fréquence 35, le convertisseur analogique-numérique 36 et la mémoire numérique 27 sont respectivement commandés par le signal $OL_2$ et des horloges $H_2$ et $H_E$ fournis également par le générateur asservi selon l'une des techniques énoncées prédédemment.

Un tel système peut ainsi être considéré comme étant insensible à la température.

Bien entendu, les mémoires numériques peuvent être remplacées par des mémoires de type analogique utilisant par exemple, des circuits à transfert de charge, dont la fréquence d'horloge lecture ou écriture est fournie par le générateur asservi. Dans ce cas, les convertisseurs 33 et 36 sont supprimés.

Le principe de fonctionnement est de faire subir au signal d'entrées des variations identiques aux variations que subissent les ondes élastiques sur le substrat du dispositif.

Le fait d'écrire et de lire dans la mémoire d'entrée 23 avec des fréquences d'horloge différentes $f_e$ et $F_L$, produit sur le signal lu $S_1$ une compression ou une dilatation de l'échelle des temps par rapport au signal inscrit $S_e$.

On obtient une échelle des temps identique à l'entrée et à la sortie du dispositif en écrivant le signal $S_4$ dans la mémoire de sortie 27 avec un signal d'horloge $H_E$ asservi de la même façon que le signal d'horloge $H_L$ de la mémoire d'entrée.

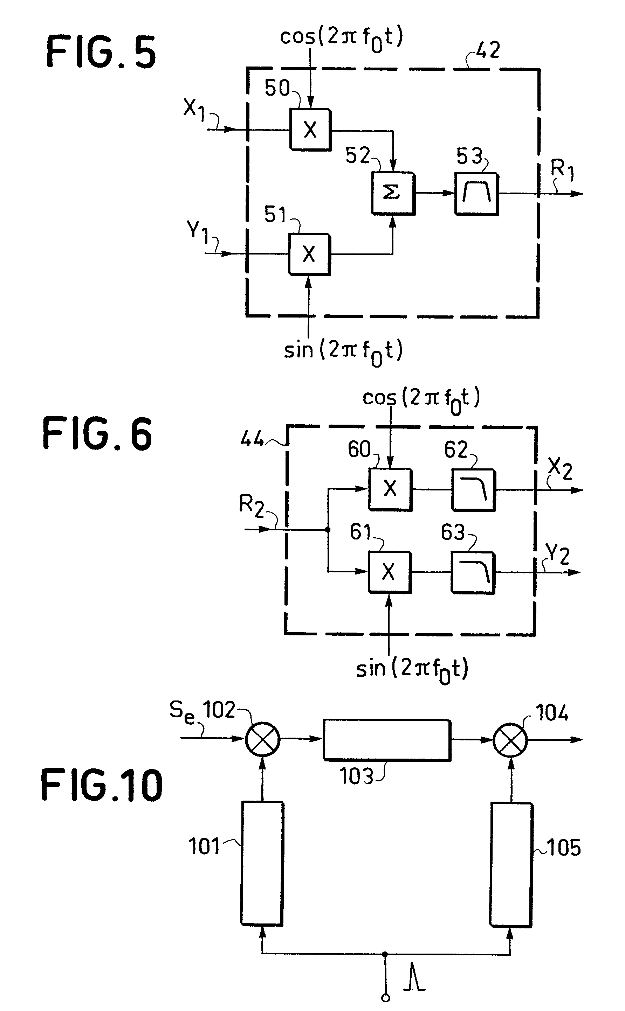

La figure 4 représente le synoptique général d'une application relative à la compression d'impulsion, avec une ligne à retard dispersive 43 à ondes élastiques.

L'entrée de la ligne est connectée à une mémoire d'entrée 41, commandée à la lecture par une horloge $H_L$ et à un modulateur 42 commandé par l'oscillateur local $OL_1$. La sortie de la ligne est connectée à une mémoire de sortie 49 commandée à l'écriture par une horloge $H_E$ et à un démodulateur 44 commandé par l'oscillateur local $OL_1$. Selon l'invention, les signaux $H_L$, $H_E$ et $OL_1$ sont fournis par un générateur asservi formé de l'ensemble de circuit 32 lui-même piloté par un oscillateur composé d'un amplificateur 304 et d'un résonateur à ondes de surface 30 placé dans la même enceinte 48 que la ligne 43, oscillateur dont la variation relative de fréquence $\frac{\Delta f}{f^1}$ 1 est fonction de la température du substrat de cette ligne à retard 43.

Dans une mémoire d'entrée 41 sont inscrits, à la cadence de l'horloge fixe $h_E$, les composantes réelles et imaginaires $X_e$ et $Y_e$ d'un signal à traiter.

Les deux blocs de la mémoire 41 sont lus à la cadence $H_L$ fournis par le générateur asservi. Les signaux de sortie $X_1$ et $Y_1$ sont appliqués à un modulateur 42 représenté par la figure 5.

Les signaux $X_1$ et $Y_1$ sont multipliés respectivement par $\cos(2\pi f_o t)$ et $\sin(2\pi f_o t)$ dans les circuits 50 et 51 et additionnés dans le circuit 52 et filtrés autour de $f_o$ par le filtre 53. $f_o$ est la fréquence centrale de fonctionnement de la ligne dispersive 43. Les signaux $OL_1$ à la fréquence $f_o$ sont fournis par le générateur asservi.

Le signal ainsi modulé $R_1$ est formé d'une impulsion modulée linéairement en fréquence de durée $T_1$ et de bande B centré autour de la fréquence transposée $f_o$. La ligne a une loi de retard linéaire avec la fréquence de sorte que si sa pente est inverse de celle du signal d'entrée, on obtient en sortie une impulsion comprimée dans le temps, $R_2$. Cette impulsion $R_2$ est ensuite démodulée dans le circuit 44, représenté sur la figure 6. Le signal $R_2$ est multiplié dans les circuits 60 et 61 par $\cos(2\pi f_0 t)$ et $\sin(2\pi f_0 t)$ où la fréquence $f_0$ est fournie par l'oscillateur $OL_1$. Les deux signaux $X_2$ et $Y_2$ obtenus sont ensuite filtrés dans deux filtres passe-bas 62 et 63 dont la fréquence de coupure est supérieure à B/2. Les deux composantes sont ensuite stockées dans la mémoire 49.

Si l'échelle de temps n'intervient pas dans l'utilisation du signal de sortie, le modulateur 44 et la mémoire 49 peuvent être supprimés.

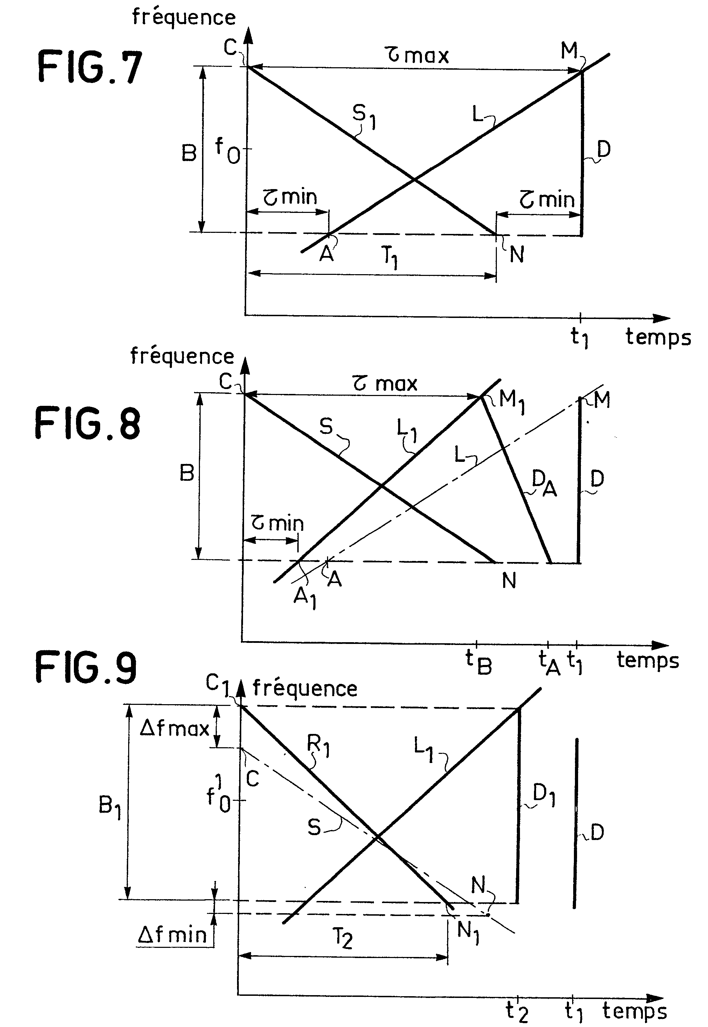

Sur la figure 7, on a représenté un signal $S_1$ de durée $T_1$ et de bande B modulé linéairement en fréquence, dans le plan fréquence f-temps t. Les points C et N représentent les limites de ce signal. Sur cette figure est représentée également la droite L représentant la loi fréquence-retard d'une ligne dispersive adaptée au signal $S_1$. Les points M et A de L correspondent aux retards maximum et minimum $\tau_{max}$ et $\tau_{min}$. Avec $\tau_{max} = T_1 + \tau_{min}$.

Au temps $t_1 = \tau_{max}$ est obtenue l'impulsion comprimée représentée par la droite verticale D sur la figure. Si la température T varie de $\Delta T$, la loi de variation L des retards $\tau$ en fonction de la fréquence f varie. Cette nouvelle loi $L_1$ est telle que f est changé en $f(1 + Q)$ et $\tau$ en $\tau(1 - Q)$, où $Q = K\Delta T$.

La figure 8 montre la compression d'un signal $S_1$ par la loi de dispersion $L_1$ correspondant à la température $T + \Delta T$. Les points M et A de la droite L sont remplacés par les points $M_1$ et $A_1$ de la droite $L_1$. Cette figure montre que l'impulsion résultante $D_A$ a une durée de $t_A - t_B$, les temps $t_A$ et $t_B$ étant obtenus en prenant les nouvelles valeurs de $\tau_{max}$ et de $\tau_{min}$.

Sur la figure 9, on a représenté le signal d'entrée $R_1$ comprimé suivant l'invention. En lisant le signal dans la mémoire d'entrée 41 avec une horloge dont la dérive en fréquence $\Delta F_L$ est telle que:

$$\frac{\Delta F}{F_L} L = Q \text{ et en modulant dans le modulateur 42}$$

autour d'une fréquence $f^1_o = f_o(\frac{L}{1} + Q)$, on obtient le signal $R_1$ limité aux points $C_1$ et $N_1$ à l'entrée de la ligne 43. Ce signal est adapté à la loi fréquence-retard $L_1$ et en sortie on obtient un signal $D_1$ correctement comprimé à l'instant $t_2 = t_1(1-Q)$ dans la bande $B_1 = (1 + Q)B$ et sur la durée $T_2 = T_1(1-Q)$.

Afin de retrouver le signal comprimé D avec la bonne échelle des temps, le signal de sortie est écrit dans la mémoire 49 de telle sorte que l'instant $t_2$ coïncide avec l'instant $t_1$ dans cette nouvelle échelle de temps. Ce résultat est obtenu suivant l'invention. Egalement la fréquence de démodulation du circuit 44 suit la dérive $\frac{\Delta f}{f}$ de la ligne, de manière à démoduler suivant la fréquence $f^1_o$.

Pour certaines utilisations le signal peut être exploité directement en sortie du dispositif, le circuit 44 et la mémoire 49 pouvant être supprimés.

A titre d'exemple dans le cas d'un substrat en Niobate de Lithium taillé suivant la coupe Y–Z,

$$K = -\frac{1}{\tau} \frac{\delta\tau}{\delta T} = -94.10^{-6}/°C.$$

Pour une fréquence horloge $F_L = 20$ MHz et une variation de température de 30 °C, la variation de fréquence est égale à environ 60 kHz.

Il est connu de réaliser la transformée de Fourier d'un signal en utilisant plusieurs lignes à retard dispersives, ou filtres dispersifs, analogue à la ligne 43 de l'application précédente.

La figure 10 représente une réalisation d'un transformateur de Fourier suivant le montage appelé M.C.M. (multiplication-convolution-multiplication).

Dans ce montage, le signal d'entrée $S_e$ est multiplié dans un circuit multiplicateur 102 par un signal, appelé «rampe» modulé linéairement en fréquence de bande $B_R$ et de durée $T_R$, autour de la fréquence centrale $F_R$. Ce signal est obtenu en envoyant une impulsion très brève à l'entrée d'un filtre dispersif 101. Le signal obtenu en sortie du multiplicateur 102 est convolué dans un filtre dispersif 103 de bande $B_c$ et de durée $T_c$ autour de la fréquence centrale $F_c$. Les pentes des deux filtres dispersifs 101 et 103 sont égales et de signe opposé de sorte que:

$$\alpha = \frac{B_R}{T_R} = -\frac{B_c}{T_c} \ .$$

Le signal en sortie du filtre de convolution est multiplié dans un multiplicateur 104 par un signal

$$t'_{Fo} = (1-Q) \ \left[ \tau_R + \tau_c + \frac{T_R + T_c}{2} \right] + \frac{1}{\alpha} \ (F_R - F_c - \frac{F_o}{1 + Q} \ )$$

D'après cette expression, en faisant varier les fréquences à l'entrée de façon que $\dfrac{\Delta F}{F} = Q$ et en mesurant le temps en sortie avec une horloge dont la variation en température est telle que:

$$\frac{\Delta T_H}{T_H} = -Q,$$

le système devient invariant avec la température, ce qui est réalisé suivant l'invention.

On a ainsi décrit une invention qui est particulièrement intéressant pour les systèmes qui travaillent déjà en temps différé et qui comportent des mémoires pour stocker les signaux en entrée et en sortie. Une application très répandue, et pour laquelle l'invention est très intéressante, est celle concernant les analyseurs de spectre utilisant des filtres dispersifs à ondes élastiques de type appelé «RAC», qui est l'abréviation de «Reflective-Array Compressor», dans lesquels des sillons réfléchissants sont gravés à la surface du substrat, leur distance étant égale à la longueur d'onde qui est réfléchie à cet endroit. L'invention s'applique également aux dispositifs convoluteurs à ondes élastiques de surface qui sont utilisés dans de nombreux traitements, tels que le filtrage adapté au traitement du signal issu d'un radar latéral à antenne synthétique.

Le choix d'un oscillateur à ondes élastiques de surface réalisé avec un substrat de même dérive en température, que celui ou ceux utilisés par le dispositif de traitement est la réalisation préférée de l'invention.

**Revendications**

1. Système de traitement de signaux ayant des performances indépendantes de la température, utilisant un dispositif à ondes élastiques (21) comportant un substrat (10) sur lequel les ondes élastiques se propagent à une vitesse variable

de rampe identique au précédent, fourni par un filtre dispersif 105. On obtient en sortie la transformée de Fourier du signal d'entrée, une fréquence étant représentée par un temps d'arrivée.

Si $\tau_R$ et $\tau_c$ sont les retards les plus petits dans les bandes correspondant aux filtres dispersifs 101 et 103 le temps d'arrivée à une température donnée pour une fréquence $F_o$ est:

$$t_{Fo} = \tau_R + \tau_c + \frac{T_R + T_c}{2} + \frac{1}{\alpha} \ (F_R - F_c - F_o)$$

A une autre température qui diffère de $\Delta T$ de la précédente, les durées et retards varient de $1-Q$, avec $Q=K\Delta T$, tandis que les fréquences varient de $1+Q$. La perte $\alpha$ devient $\alpha \dfrac{1+Q}{1-Q}$ et le temps d'arrivée est égal a:

avec la température, caractérisé en ce qu'il comprend en outre:
– une mémoire d'entrée (23) pour recevoir le signal à traiter et le restituer au dispositif à ondes élastiques (21);
– un générateur de signal d'horloge à fréquence fixe (20) pour inscrire le signal à traiter dans la mémoire d'entrée;
– un générateur de signal d'horloge à fréquence variable (22) pour lire le signal à traiter dans la mémoire d'entrée;
– des moyens (24) pour mesurer la température du substrat (10) du dispositif à ondes élastiques (21) et asservir la fréquence du générateur à fréquence variable de telle manière que l'échelle de temps du signal à traiter lu dans la mémoire d'entrée soit modifiée pour s'adapter aux variations de la vitesse des ondes élastiques sur le substrat.

2. Un système selon la revendication 1, caractérisé en ce que la fréquence FI du générateur à fréquence variable (22) varie avec la température T du substrat (20) selon une loi $\dfrac{1}{FI} \times \dfrac{\delta FI}{\delta T} = K$, où K est une constante dépendant du matériau et de la coupe du substrat.

3. Un système selon l'une quelconque des revendications 1 et 2, caractérisé en ce qu'il comprend en outre une mémoire de sortie (27) pour recevoir sous la commande du générateur à fréquence variable (22) le signal traité par le dispositif à ondes élastiques (21) et le délivrer en sortie du système sous la commande du générateur à fréquence fixe (20) dans l'échelle de temps initiale du signal à traiter.

4. Un système selon l'une quelconque des revendications 1 à 3, caractérisé en ce que les moyens de mesure (24) de la température du substrat comprennent un oscillateur comportant un dispositif à ondes élastiques (30) réalisé sur un substrat ayant les mêmes caractéristiques que le substrat du dispositif à ondes élastiques (31) servant au traitement du signal.

5. Un système selon la revendication 4, caractérisé en ce que le substrat du dispositif à ondes élastiques (30) de l'oscillateur est commun avec le substrat du dispositif à ondes élastiques (31) servant au traitement du signal.

6. Un système selon l'une quelconque des revendications 1 à 5, caractérisé en ce qu'il comprend en outre au moins un circuit d'interface (25) permettant d'adapter le signal fourni par la mémoire d'entrée (23) aux caractéristiques du dispositif à ondes élastiques (21) de traitement du signal.

7. Un système selon la revendication 6, caractérisé en ce que le circuit d'interface (25) comprend au moins un modulateur (35) permettant de moduler par le signal fourni par la mémoire d'entrée une porteuse à fréquence variable selon la température du substrat (10) et fournie par le générateur de signal d'horloge (22) à fréquence variable.

## Patentansprüche

1. Verarbeitungssystem für Signale mit temperaturunabhängigem Verhalten, unter Verwendung einer Elastikwellenvorrichtung (21) mit einem Substrat (10), auf dem die elastischen Wellen sich mit von der Temperatur abhängiger Geschwindigkeit fortpflanzen, dadurch gekennzeichnet, dass es ausserdem enthält
— einen Eingangsspeicher (23), der das zu verarbeitende Signal zugeführt erhält und es an die Elastikwellenvorrichtung (21) abgibt;
— einen Taktsignalgenerator (20) mit dessen Hilfe das zu verarbeitende Signal in den Eingangsspeicher eingeschrieben wird;
— einen Taktsignalgenerator (22) mit variabler Frequenz, mit dessen Hilfe das zu bearbeitende Signal aus dem Eingangsspeicher ausgelesen wird;
— Mittel (24) zur Messung der Temperatur des Substrats (10) der Elastikwellenvorrichtung (21) und zur Nachführung der Frequenz des variablen Frequenzgenerators derart, dass der Zeitmassstab des zu bearbeitenden Signals, das aus dem Eingangsspeicher ausgelesen wird, zur Anpassung an die Geschwindigkeitsveränderungen der elastischen Wellen auf dem Substrat verändert wird.

2. System nach Anspruch 1, dadurch gekennzeichnet, dass die Frequenz FI des variablen Frequenzgenerators (22) mit der Temperatur T des Substrats (20) gemäss einem Gesetz

$$\frac{1}{FI} \times \frac{\delta FI}{\delta T} = K$$

variiert, wobei K eine Konstante ist, die vom Material und dem Schnitt des Substrats abhängt.

3. System nach einem beliebigen der Ansprüche 1 und 2, dadurch gekennzeichnet, dass es ausserdem einen Ausgangsspeicher (27) enthält, dem unter Steuerung durch den variablen Frequenzgenerator (22) das durch die Elastikwellenvorrichtung (21) behandelte Signal zugeführt wird und der dieses Signal an den Ausgang des Systems unter Steuerung durch den Festfrequenzgenerator (20) im ursprünglichen Zeitmassstab des zu bearbeitenden Signals abgibt.

4. System nach einem beliebigen der Ansprüche 1 bis 3, dadurch gekennzeichnet, dass die Mittel (24) zur Messung der Temperatur des Substrats einen Oszillator mit einer Elastikwellenvorrichtung enthalten (30), der auf einem Substrat mit denselben Kennwerten wie das Substrat der der Signalverarbeitung dienenden Elastikwellenvorrichtung (31) realisiert ist.

5. System nach Anspruch 4, dadurch gekennzeichnet, dass das Substrat der Elastikwellenvorrichtung (30) des Oszillators mit dem Substrat der Elastikwellenvorrichtung (31) gemein ist, die der Verarbeitung des Signals dient.

6. System nach einem beliebigen der Ansprüche 1 bis 5, dadurch gekennzeichnet, dass es ausserdem mindestens einen Interface-Schaltkreis (25) enthält, mit dem das vom Eingangsspeicher (23) gelieferte Signal an die Kennwerte der Elastikwellenvorrichtung (21) für die Verarbeitung des Signals angepasst werden kann.

7. System nach Anspruch 6, dadurch gekennzeichnet, dass der Interface-Schaltkreis (25) mindestens einen Modulator (35) enthält, in dem mit dem vom Eingangsspeicher gelieferten Signal ein Träger moduliert werden kann, der eine von der Temperatur des Substrats (10) variable Frequenz besitzt, die vom frequenzvariablen Taktsignalgenerator (22) geliefert wird.

## Claims

1. A signal processing system having performances independent of the temperature, using an elastic wave device (21) comprising a substrate (10) on which the elastic waves are propagated at a speed variable with temperature, characterized in that it further comprises:
— an input memory (23) for receiving the signal to be processed and to deliver it to the elastic wave device;
— a clock signal generator (20) having a constant frequency used to inscribe the signal to be processed into the input memory;
— a clock signal generator (22) having a variable frequency used to read the signal to be processed from the input memory;
— means (24) for measuring the temperature of the substrate (10) of the elastic wave device (21) and for adjusting the frequency of the variable frequency generator in such a way that the time scale of the signal to be processed which is read from the input memory is modified in view of its adaptation to the speed variations of the elastic waves propagated on the substrate.

2. A system according to claim 1, characterized in that the frequency FI of the variable frequency generator (22) varies with the temperature T of the substrate (20) according to a law

$$\frac{1}{FI} \times \frac{\delta FI}{\delta T} = K$$

in which K is a constant value depending on the material and the cut of the substrate.

3. A system according to any one of claims 1 and 2, characterized in that it further comprises an output memory (27) which receives under the control of the variable frequency generator (22) the signal which has been processed by the elastic wave device (21), and which restitutes it to the output of the system under the control of the constant frequency generator (20) along the initial time scale of the signal to be processed.

4. A system according to any one of claims 1 to 3, characterized in that the means (24) for measuring the temperature of the substrate comprise an oscillator having an elastic wave device (30), this device being realized on a substrate having the same characteristics as the substrate of the elastic wave device (31) used for processing the signal.

5. A system according to claim 4, characterized in that the substrate of the elastic wave device (30) of the oscillator is common with the substrate of the elastic wave device (31) used for processing the signal.

6. A system according to any one of claims 1 to 5, characterized in that it further comprises at least an interface circuit (25) which is conceived to adapt the signal delivered by the input memory (23) to the characteristics of the elastic wave device (21) used for processing the signal.

7. A system according to claim 6, characterized in that the interface circuit (25) comprises at least one modulator (35) conceived to modulate, by the signal coming from the input memory, a carrier which is variable in frequency according to the temperature of the substrate (10) and which is furnished by the variable frequency clock signal generator (22).

# FIG.1

10

11    12

ℓ    L

# FIG.2

HORLOGE FIXE

20

23    $h_E$    25    INTERFACE    21    INTERFACE    26    27    $h_L$

$S_e$    $S_1$    $S_2$    DISPOSITIF A ONDES ELASTIQUES    $S_3$    $S_4$    $S_s$

MEMOIRE D'ENTREE    $H_L$    $H_{20}$    24    $H_{21}$    $H_E$

ASSERVISSEMENT    22    MEMOIRE DE SORTIE

HORLOGE VARIABLE

$X_e$    41    INTERFACE    48    43    INTERFACE    49    $X_s$

42    $R_1$    44

$X_1$    $R_2$

MEMOIRE D'ENTREE    $Y_1$    LIGNE A RETARD    MEMOIRE DE SORTIE    $Y_s$

$Y_e$    $OL_1$    RESONATEUR    $OL_1$

$H_L$    $h_E$    $H_E$    $h_L$

30

304    $f_1$    HORLOGE VARIABLE    32

$H_L$    $H_E$

$OL_1$

# FIG.4

0 063 069

# FIG. 3

**FIG.5**

$\cos(2\pi f_0 t)$

$X_1$

50 — $\boxed{X}$

52

53

$\boxed{\Sigma}$ → $\boxed{\phantom{xx}}$ → $R_1$

51

$Y_1$ — $\boxed{X}$

$\sin(2\pi f_0 t)$

42

**FIG.6**

$\cos(2\pi f_0 t)$

44

60 — $\boxed{X}$   62 → $X_2$

$R_2$

61 — $\boxed{X}$   63 → $Y_2$

$\sin(2\pi f_0 t)$

**FIG.10**

$S_e$  102 — $\otimes$ → $\boxed{\phantom{xxx}}$ → $\otimes$ — 104

101   103   105

# FIG.7

fréquence

$\tau$ max

C M

$S_1$ L

B $f_0$ D

$\tau$ min $\tau$ min

A N

$T_1$

$t_1$ temps

# FIG.8

fréquence

$\tau$ max

C $M_1$ M

S $L_1$

L

B D_A D

$\tau$ min

$A_1$ A N

$t_B$ $t_A$ $t_1$ temps

# FIG.9

$C_1$ fréquence

$\Delta f$ max

$R_1$ $L_1$

C

$B_1$ $f_0^1$ $D_1$

S D

N

$\Delta f$ min $N_1$

$T_2$

$t_2$ $t_1$ temps